(19) Europäisches Patentamt / European Patent Office / Office européen des brevets

(11) **EP 3 605 289 A1**

(12) **EUROPEAN PATENT APPLICATION**
published in accordance with Art. 153(4) EPC

(43) Date of publication:
**05.02.2020 Bulletin 2020/06**

(51) Int Cl.:
*G06F 3/041* (2006.01)     *G06F 3/044* (2006.01)
*H05K 1/02* (2006.01)

(21) Application number: **18775608.5**

(22) Date of filing: **26.03.2018**

(86) International application number:
**PCT/JP2018/012129**

(87) International publication number:
**WO 2018/181175 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2017 JP 2017072259**

(71) Applicant: **Fujikura Ltd.**
**Tokyo 135-8512 (JP)**

(72) Inventors:
• **SHIOJIRI, Takeshi**
 **Sakura-shi**
 **Chiba 285-8550 (JP)**
• **ISHII, Masaaki**
 **Sakura-shi**
 **Chiba 285-8550 (JP)**

(74) Representative: **Ter Meer Steinmeister & Partner Patentanwälte mbB**
**Artur-Ladebeck-Strasse 51**
**33617 Bielefeld (DE)**

(54) **WIRING BODY, WIRING SUBSTRATE, AND TOUCH SENSOR**

(57)   A wiring body (40) includes a first resin portion (50) and a first electrode (61) which is provided on the first resin portion (50) and has a mesh shape in which first conductor wires (601a) and second conductor wires (601b) to intersect with each other, and the first electrode (61) includes at least one wide portion (613) disposed to correspond to an intersection portion (602) of the first conductor wire (601a) and the second conductor wire (601b), and the following Formula (1) is satisfied.

$$6 < Sc/(La \times Lb) \leq 30 \ \dots \ (1)$$

In the above Formula (1), Sc is an area of the wide portion (613), La is a width of the first conductor wire (601a), and Lb is a width of the second conductor wire (601b).

FIG. 5

EP 3 605 289 A1

**Description**

**[TECHNICAL FIELD]**

The present invention relates to a wiring body, a wiring board, and a touch sensor.

For designated countries that are permitted to be incorporated by reference in the literature, the contents described in Japanese Patent Application No. 2017-072259 filed in Japan on March 31, 2017 are incorporated herein by reference and are regarded as a part of the description of this specification.

**[BACKGROUND ART]**

There is known a touch panel in which conductor portions having a mesh pattern of metal thin lines are included in the touch panel and moire suppression portions are formed at intersection portions of the mesh pattern (refer to, for example, Patent Document 1). In this touch panel, the area of the moire suppression portion is formed to be larger than the area of the intersection portion of the thin lines.

**[CITATION LIST]**

**[PATENT DOCUMENT]**

Patent Document 1: JP 2012-108845 A

**[SUMMARY OF THE INVENTION]**

**[PROBLEM TO BE SOLVED BY THE INVENTION]**

At intersection portions of thin lines constituting a mesh pattern in a touch panel, the intersection portions or insulating portions in the vicinity of the intersection portions are deteriorated due to the influence of thermal stress by Joule's heat generated by concentration of current from the thin lines connected to the intersection portions, and thus, there is a problem that the reliability of the touch panel may be deteriorated.

On the other hand, it is considered that, the conductor portions having a larger area than the area of the intersection portion are formed at the intersection portions of thin lines, and thus, Joule's heat generated at the intersection portions is suppressed, so that deterioration in the reliability of the touch panel is suppressed. However, if the area of the conductor portion formed at the intersection portion is too large, the conductor portion is easily visible, and thus, there is a problem in that the visibility of the touch panel may be deteriorated.

The problem to be solved by the invention is to provide a wiring body, a wiring board, and a touch sensor capable of suppressing a decrease in reliability while improving visibility.

**[MEANS FOR SOLVING PROBLEM]**

[1] A wiring body according to the invention is a wiring body includes: a resin portion; and a conductor portion which is provided on the resin portion and has a mesh shape in which first conductor wires and second conductor wires intersect with each other, in which the conductor portion includes at least one wide portion disposed to correspond to an intersection portion of the first conductor wire and the second conductor wire, and the following Formula (1) is satisfied:

$$6 < Sc/(La \times Lb) \leq 30 \ldots (1)$$

in the above Formula (1), Sc is an area of the wide portion, La is a width of the first conductor wire, and Lb is a width of the second conductor wire.

[2] In the above invention, the following Formula (2) may be satisfied.

$$6 \ \mu m^2 \leq Sc \leq 500 \ \mu m^2 \ldots (2)$$

[3] In the above invention, the following Formulas (3) and (4) may be satisfied.

$$1 \ \mu m \leq La \leq 5 \ \mu m \ \ldots \ (3)$$

$$1 \ \mu m \leq Lb \leq 5 \ \mu m \ \ldots \ (4)$$

[4] In the above invention, the conductor portion may include: sensing portions which are arranged at intervals along a predetermined direction; and connection portions which are formed to be narrower than the sensing portions and connect the sensing portions adjacent to each other, and the wide portion may be disposed to correspond to at least one of the intersection portions existing in the connection portion.

[5] In the above invention, the wide portion may be disposed to correspond to at least one of the intersection portions existing in the sensing portion, and the following Formulas (5) to (7) may be satisfied:

$$A < B \ \ldots \ (5)$$

$$A = (A_1 + A_1)/N_1 \ \ldots \ (6)$$

$$B = (B_1 + B_2)/N_2 \ \ldots \ (7)$$

in the above Formula (6), $A_1$ is a total sum of the areas of the wide portions in one of the sensing portions, $A_2$ is a total sum of the areas of the intersection portions in which the wide portions do not exist in one of the sensing portions, and $N_1$ is the number of the intersection portions in one of the sensing portions; and in the above Formula (7), $B_1$ is a total sum of the areas of the wide portions in one of the connection portions, $B_2$ is a total sum of the areas of the intersection portions in which the wide portions do not exist in one of the connection portions, and $N_2$ is the number of the intersection portions in one of the connection portions.

[6] In the above invention, in the connection portion, the number of the intersection portions that are arranged in a direction perpendicular to the extending direction of the connection portion may be three or less.

[7] In the above invention, the following Formula (8) may be satisfied:

$$La + Lb < W \ \ldots \ (8)$$

in the above Formula (8), W is a width of the wide portion.

[8] A wiring board according to the invention is a wiring board including the above-described wiring body and a support which supports the wiring body.

[9] A touch sensor according to the invention is a touch sensor including the above-described wiring board.

**[EFFECT OF THE INVENTION]**

According to the invention, it is possible to prevent thermal stress from being applied to intersection portions of conductor wires while preventing wide portions from being easily visible, so that it is possible to improve visibility and suppress decrease in reliability.

**[BRIEF DESCRIPTION OF DRAWINGS]**

Fig. 1 is a plan view illustrating a touch sensor according to an embodiment of the invention;
Fig. 2 is an exploded perspective view illustrating a wiring board according to an embodiment of the invention;
Fig. 3 is a plan view illustrating a first electrode according to an embodiment of the invention;
Fig. 4 is a plan view for describing an aperture ratio;
Fig. 5 is an enlarged plan view of a portion of a first electrode according to an embodiment of the invention;

Fig. 6 is an enlarged plan view of a portion of a first electrode according to another embodiment of the invention;

Fig. 7 is a plan view illustrating a first electrode according to another embodiment of the invention;

Fig. 8 is a plan view illustrating a second electrode according to an embodiment of the invention;

Figs. 9(A) to 9(E) are cross-sectional views (No. 1) for describing a method of manufacturing a wiring board according to an embodiment of the invention; and

Figs. 10(A) to 10(F) are cross-sectional views (No. 2) for describing the method of manufacturing the wiring board according to the embodiment of the invention.

**[MODE(S) FOR CARRYING OUT THE INVENTION]**

Hereinafter, embodiments of the invention will be described with reference to the drawings.

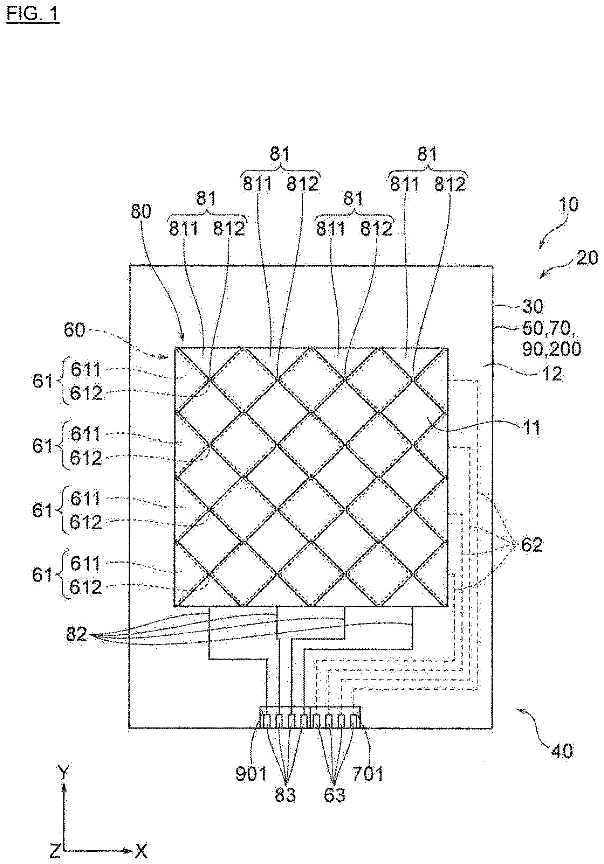

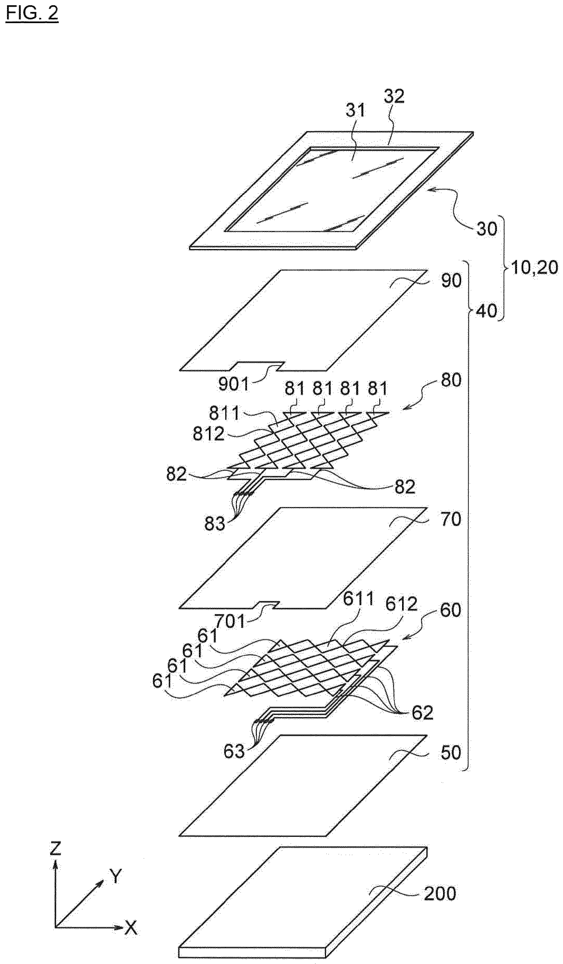

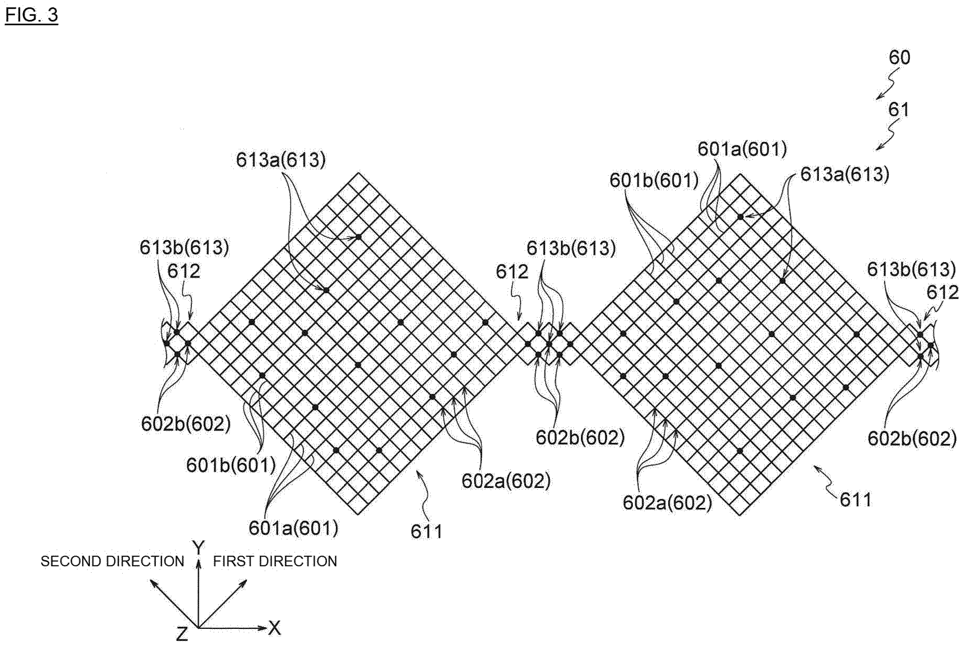

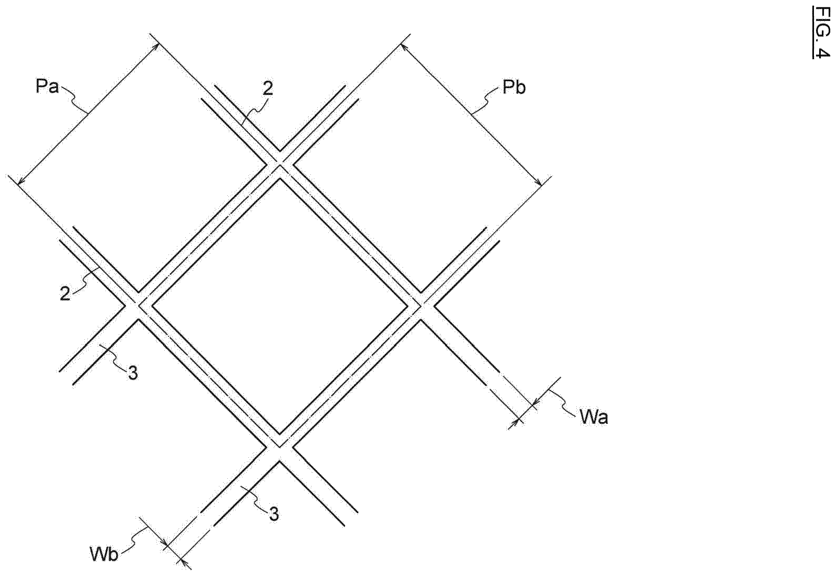

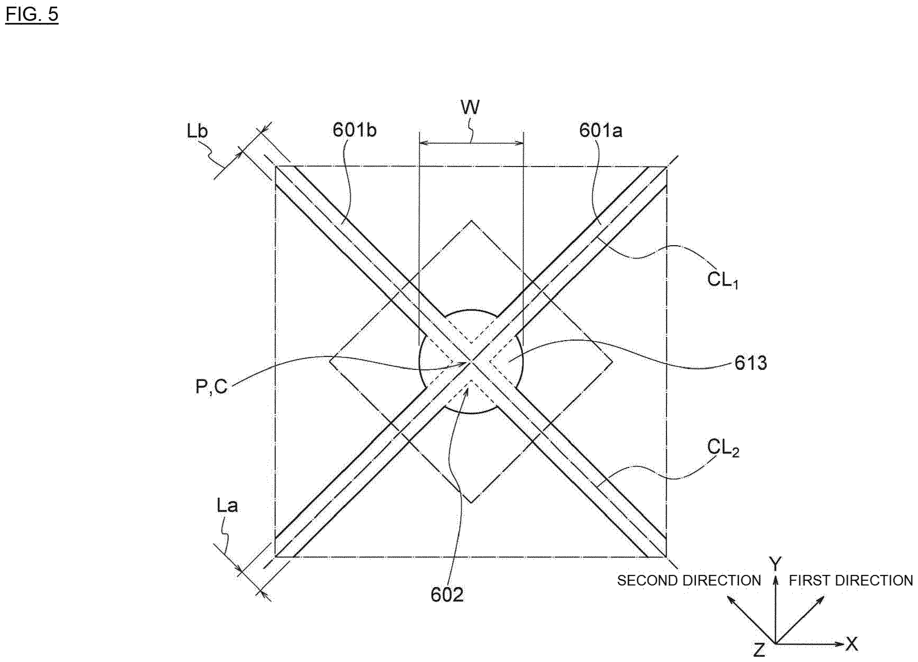

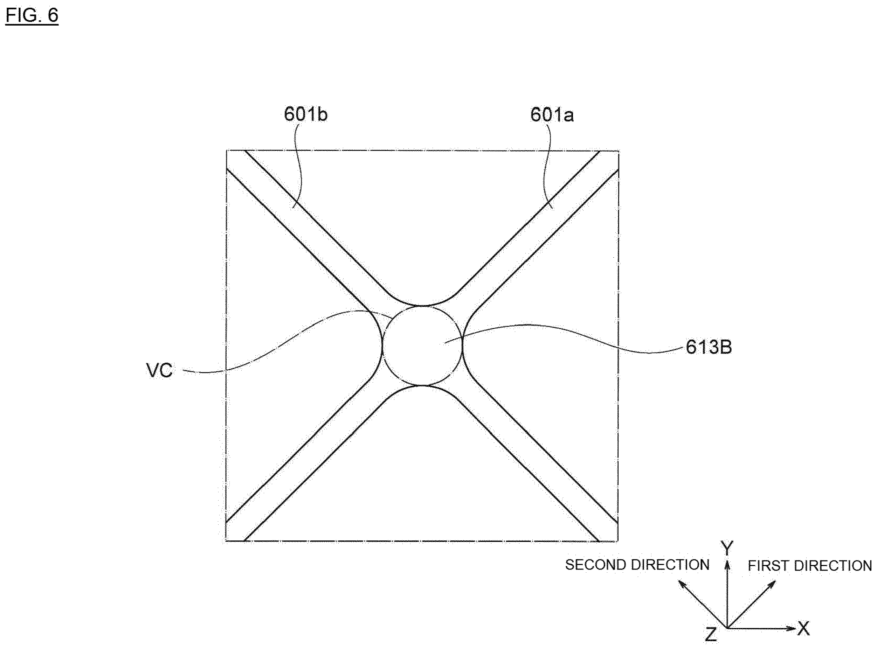

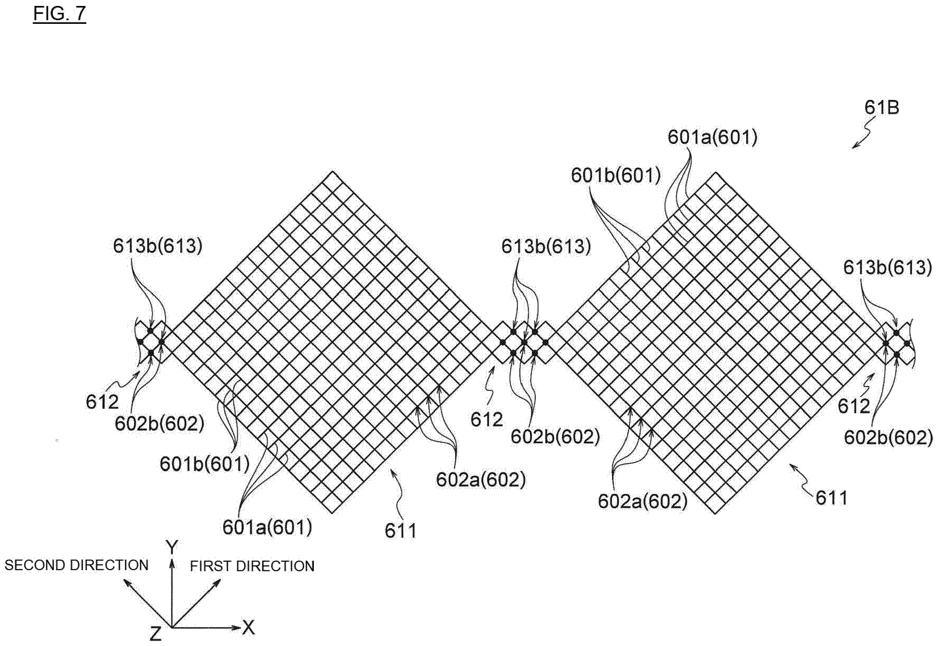

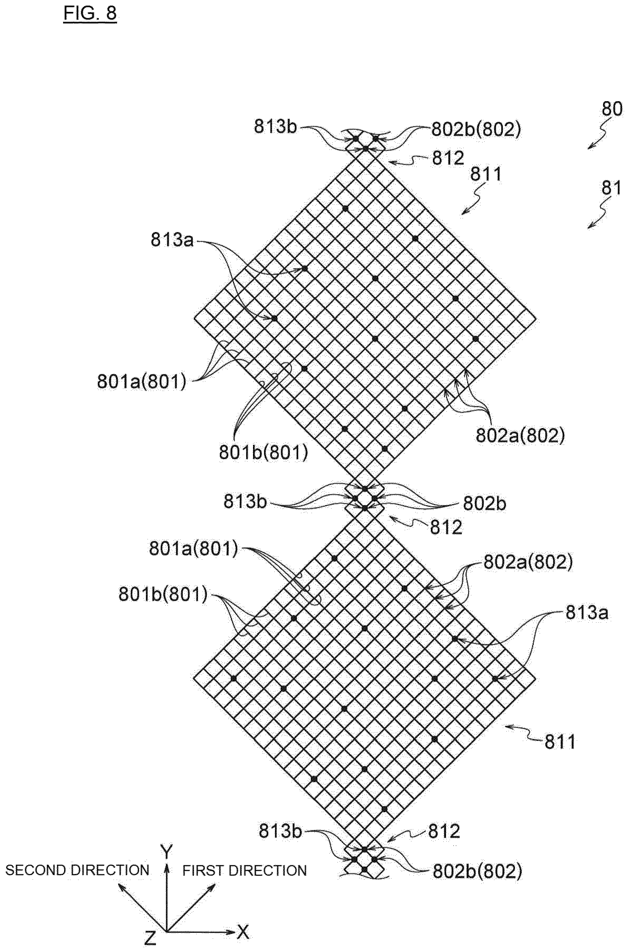

Fig. 1 is a plan view illustrating a touch sensor according to an embodiment of the invention, Fig. 2 is an exploded perspective view illustrating a wiring board according to an embodiment of the invention, Fig. 3 is a plan view illustrating a first electrode according to an embodiment of the invention, Fig. 4 is a plan view illustrating an aperture ratio, Fig. 5 is an enlarged plan view of a portion of a first electrode according to an embodiment of the invention, Fig. 6 is an enlarged plan view of a portion of a first electrode according to another embodiment of the invention, Fig. 7 is a plan view illustrating a first electrode according to another embodiment of the invention, and Fig. 8 is a plan view illustrating a second electrode according to an embodiment of the invention.

A touch sensor 10 illustrated in Fig. 1 is a projection-type electrostatic capacitive touch panel sensor and is combined with, for example, a display device (not illustrated) or the like to be used as an input device having a function of detecting a touch position. The display device is not particularly limited, and a liquid crystal display, an organic EL display, electronic paper, or the like can be used. In this touch sensor 10, a detection electrode and a drive electrode (a first electrode 61 and a second electrode 81 described later) are arranged so as to overlap with an image to be displayed on the display device, and a predetermined voltage from an external circuit (not illustrated) is periodically applied between the two electrodes 61 and 81.

In such a touch sensor 10, for example, when an operator's finger (external conductor) approaches the touch sensor 10, a capacitor (electric capacitance) is formed between the external conductor and the touch sensor 10, the electrical state between the two electrodes is changed. The touch sensor 10 can sense the operation position of the operator on the basis of the change in the electrical state between the two electrodes.

As illustrated in Figs. 1 and 2, a wiring board 20 includes a cover panel 30, a wiring body 40, and a transparent substrate 200. The wiring board 20 according to the present embodiment is configured to have a light transmission property as a whole in order to ensure the visibility of the display device.

The cover panel 30 is provided on one main surface of the wiring body 40. Such a cover panel 30 has rigidity enough to support the wiring body 40. In the present embodiment, the cover panel 30 has a rectangular outer shape and includes a transparent portion 31 capable of transmitting visible light and a shielding portion 32 shielding the visible light. The transparent portion 31 is formed in a rectangular shape, and the shielding portion 32 is formed in a rectangular frame shape around the transparent portion 31. As a material constituting the cover panel 30, for example, a glass material such as a soda lime glass and a borosilicate glass and a resin material such as polymethyl methacrylate (PMMA) and polycarbonate (PC) can be exemplified. The shielding portion 32 is formed by applying, for example, black ink to the outer peripheral portion of the back surface of the cover panel 30. In the touch sensor 10, a portion overlapping with the transparent portion 31 in plan view is a sensing area 11 where the operation position of the operator can be sensed. In the touch sensor 10, a portion overlapping with the shielding portion 32 in plan view is a non-sensing area 12 where the operation position of the operator can be sensed.

The transparent substrate 200 is provided on the other main surface of the wiring body 40. Such a transparent substrate 200 has rigidity enough to support the wiring body 40. In the present embodiment, the transparent substrate 200 has a rectangular outer shape and is made of a material having light transmission property. As the material constituting the transparent substrate 200, for example, polyethylene terephthalate (PET), polyethylene naphthalate (PEN), a polyimide resin (PI), a polyetherimide resin (PEI), polycarbonate (PC), polyether ether ketone (PEEK), a liquid crystal polymer (LCP), a cycloolefin polymer (COP), a silicone resin (SI), an acrylic resin, a phenol resin, an epoxy resin, a green sheet, a glass, and the like can be used.

As illustrated in Fig. 2, the wiring body 40 includes a first resin portion 50, a first conductor portion 60, a second resin portion 70, a second conductor portion 80, and a third resin portion 90. The wiring body 40 is configured to have a light transmission property as a whole in order to ensure the visibility of the display device.

The first resin portion 50 is provided to hold the first conductor portion 60. The first resin portion 50 has a rectangular outer shape and is made of a resin material having a light transmission property. As the resin material having a light transmission property, for example, a UV curable resin, a thermosetting resin, or a thermoplastic resin such as an epoxy resin, an acrylic resin, a polyester resin, a urethane resin, a vinyl resin, a silicone resin, a phenol resin, or a polyimide resin can be exemplified.

The first conductor portion 60 is provided on the first resin portion 50. As illustrated in Fig. 3, the first conductor portion 60 is configured in a mesh shape of a plurality of conductor wires 601. Specifically, the first conductor portion 60 having a mesh shape in which square grids are repeatedly arranged is configured by allowing a plurality of first conductor wires 601a extending in a linear shape along a direction (hereinafter, also referred to as a "first direction") inclined with respect to the X direction and a plurality of second conductor wires 601b extending along a direction(hereinafter, also referred to as a "second direction") different from the first direction to intersect with each other. In the present specification, the "first conductor wire 601a" and the "second conductor wire 601b" are collectively referred to as the "conductor wire 601" as necessary.

The conductor wire 601 of the first conductor portion 60 is not limited to have a linear shape, and the conductor wire 601 may have a curved shape. It is preferable that the width of the conductor wire 601 is substantially constant in the extending direction of the conductor wire 601. It is preferable that the width La of the first conductor wire 601a is set in a range of 1 to 5 $\mu$m (1 $\mu$m $\leq$ La $\leq$ 5 $\mu$m). It is preferable that the width Lb of the second conductor wire 601b is set in a range of 1 to 5 $\mu$m (1 $\mu$m $\leq$ Lb $\leq$ 5 $\mu$m).

The configuration of the first conductor portion 60 is not particularly limited to that described above. For example, in the present embodiment, the pitch between the first conductor wires 601a and the pitch between the second conductor wires 601b are set to be the same. However, the pitch between the first conductor wires 601a and the pitch between the second conductor wires 601b may be set to be different from each other. The width and pitch of the conductor wires 601 constituting the first conductor portion 60 are not particularly limited to those described above, and it is preferable that the width and pitch of the conductor wires 601 are set so that the aperture ratio of the first electrode 61 (described later) is in a range of 96.5 to 98.0%.

The "aperture ratio" is a ratio represented by the following Formula (7) (refer to Fig. 4).

$$(\text{Aperture Ratio}) = (Pa - Wb) \times (Pb - Wa)/(Pa \times Pb) \dots (7)$$

In the above Formula (7), Wa is a width of the conductor wire 2, Wb is a width of the conductor wire 3, Pa is a pitch (distance between centers of the conductor wires 2 adjacent to each other) between an arbitrary conductor wire 2 and another conductor wire 2 adjacent to the conductor wire 2, and Pb is a distance between an arbitrary conductor wire 3 and another conductor wire 3 adjacent to the conductor wire 3.

The shape of the grid included in the first conductor portion 60 is not particularly limited. For example, the shape of the grid may be a triangle such as an equilateral triangle, an isosceles triangle, or a right triangle or a quadrilateral such as a parallelogram or a trapezoid. The shape of the grid may be an n-polygon such as a hexagon, an octagon, a dodecagon, or an icosagon, a circle, an ellipse, a star shape, or the like. In this manner, a geometric pattern obtained by repeating various graphic units can be used as the shape of the grid of the first conductor portion 60.

Such a first conductor portion 60 is made of a conductive material and a binder resin. As the conductive material, a metal material such as silver, copper, nickel, tin, bismuth, zinc, indium, or palladium, a carbon-based material such as graphite, carbon black (furnace black, acetylene black, or ketjen black), carbon nanotube, or carbon nanofiber can be exemplified. As a conductive material, a metal salt may be used. As a metal salt, a salt of the above-mentioned metal can be mentioned.

As a binder resin, an acrylic resin, a polyester resin, an epoxy resin, a vinyl resin, a urethane resin, a phenol resin, a polyimide resin, a silicone resin, a fluorine resin, and the like can be exemplified.

Such a first conductor portion 60 is formed by applying and solidifying (curing) a conductive paste. As a specific example of the conductive paste, a conductive paste formed by mixing the above-mentioned conductive material and binder resin with water or a solvent and various additives can be exemplified. As a solvent contained in the conductive paste, $\alpha$-terpineol, butyl carbitol acetate, butyl carbitol, 1-decanol, butyl cellosolve, diethylene glycol monoethyl ether acetate, tetradecane, and the like can be exemplified. The binder resin may be omitted from the material constituting the first conductor portion 60.

As illustrated in Figs. 1 and 2, the first conductor portion 60 includes the first electrodes 61, first lead wires 62, and first terminals 63. The first electrode 61 is disposed so as to at least partially overlap with the sensing area 11. Each first electrode 61 extends in the X direction in the figure, and the plurality of first electrodes 61 are arranged in parallel to the Y direction in the figure. One end of the first lead wire 62 is connected to one longitudinal end of each first electrode 61. The first terminal 63 is connected to the other end of each of the first lead wires 62. The first terminal 63 is electrically connected to, for example, an external circuit. The first lead wire 62 and the first terminal 63 are disposed to overlap with the non-sensing area 12.

The number of the first electrodes 61 is not particularly limited and can be set arbitrarily. In addition, the number of the first lead wires 62 and the number of the first terminals 63 are set according to the number of the first electrodes 61. The first lead wire 62 and the first terminal 63 may be configured in a mesh shape or may be configured in a solid pattern.

As illustrated in Fig. 3, the first electrode 61 is configured in a mesh shape of the plurality of conductor wires 601. The first electrode 61 includes a plurality of first sensing portions 611 which are in a rhombic shape in plan view and a plurality of strip-shaped first connection portions 612, each of which is formed to be narrower than the first sensing portion 611. The first sensing portion 611 is configured to have a mesh shape of the plurality of conductor wires 601, and the plurality of first sensing portions 611 are arranged at substantially equal intervals along the X direction with intervals. The first connection portion 612 is also configured to have a mesh shape of the plurality of conductor wires 601, and the plurality of first connection portions 612 electrically connect the corner portions of the adjacent first sensing portions 611 to each other. In the first connection portion 612, the number of intersection portions 602 (specifically, second intersection portions 602b (described later)) which are arranged in a direction perpendicular to the extending direction (X direction) of the first connection portion 612 is preferably three or less.

As illustrated in Fig. 5, a wide portion 613 is formed at the intersection portion 602 of the first conductor wire 601a and the second conductor wire 601b (strictly speaking, the intersection portion 602 of an extension line of the first conductor wire 601a and an extension line of the second conductor wire 601b) in the first electrode 61. In the present embodiment, the wide portions 613 are arranged so that the center C of the wide portion 613 substantially matches with an intersection point P of a center line $CL_1$ of the first conductor wire 601a and a center line $CL_2$ of the second conductor wire 601b in plan view. The correspondence between the intersection portion 602 and the wide portion 613 is not particularly limited to that described above as long as the intersection point P exists inside the outline of the wide portion 613 in plan view. "The center C of the wide portion" is "the gravity center of the wide portion".

The width W of the wide portion 613 is larger than the width of the conductor wire 601 (the first conductor wire 601a or the second conductor wire 601b which has the larger width). The width W of the wide portion 613 corresponds to the diameter of a virtual circle inscribed in the wide portion 613, and in a case where the wide portion 613 has a substantially circular shape, the width W of the wide portion 613 corresponds to the diameter of the wide portion 613.

Each wide portion 613 has a substantially perfect circular shape in plan view. The shape of the wide portion 613 is not particularly limited to that described above. For example, the shape of the wide portion 613 may be a triangle such as an equilateral triangle, an isosceles triangle, or a right triangle or a quadrilateral such as a parallelogram or a trapezoid. The shape of the wide portion 613 may be an n-polygon such as a hexagon, an octagon, a dodecagon, or an icosagon, a circle, an ellipse, a star shape, a cross shape or the like. For example, as illustrated in Fig. 6, in a case where a wide portion 613B is divided into four portions by the center lines of the first and second conductor wires 601a and 601b, each of the four divided portions of the wide portion 613B may have a shape in which an arc-shaped notch is formed in a triangle. The virtual circle VC illustrated in Fig. 6 is a virtual circle inscribed in the wide portion 613B, and the diameter of the virtual circle VC corresponds to the width of the wide portion 613B. In this manner, a geometric pattern obtained by repeating various graphic units can be used as the shape of the wide portion 613.

In the present embodiment, the material constituting the conductor wire 601 and the material constituting the wide portion 613 are substantially the same, and thus, the conductor wire 601 and the wide portion 613 are integrally formed. In Fig. 5, the boundary between the conductor wire 601 and the wide portion 613 is indicated by a broken line. The material constituting the conductor wire 601 and the material constituting the wide portion 613 may be different.

In the present embodiment, the relationship of the area Sc of the wide portion 613, the width La of the first conductor wire 601a connected to the wide portion 613, and the width Lb of the second conductor wire 601b connected to the wide portion 613 satisfies the following Formula (9). The relationship between the area Sc of the wide portion 613, the width La of the first conductor wire 601a, and the width Lb of the second conductor wire 601b more preferably satisfies the following Formula (10).

$$6 < Sc/(La \times Lb) \le 30 \dots (9)$$

$$6 < Sc/(La \times Lb) \le 18 \dots (10)$$

Such an area Sc of the wide portion 613 is preferably in a range of 6 $\mu m^2$ to 500 $\mu m^2$ (6 $\mu m^2 \le Sc \le 500$ $\mu m^2$).

In the present embodiment, the relationship of the width W of the wide portion 613, the width La of the first conductor wire 601a, and the width Lb of the second conductor wire 601b preferably satisfies the following Formula (11), more preferably satisfies the following Formula (12).

$$La + Lb < W \dots (11)$$

$$1.5 \le W/(La + Lb) \le 2.0 \ldots (12)$$

Furthermore, as illustrated in Fig. 3, a first wide portion 613a is disposed at a first intersection portion 602a of the first conductor wire 601a and the second conductor wire 601b in the first sensing portion 611, and a second wide portion 613b is disposed at a second intersection portion 602b of the first conductor wire 601a and the second conductor wire 601b in the first connection portion 612. In the present specification, the "first intersection portion 602a" and the "second intersection portion 602b" are collectively referred to as the "intersection portion 602", and the "first wide portion 613a" and the "second wide portion 613b" are collectively referred to as the "wide portion 613" as necessary.

The first wide portion 613a and the second wide portion 613b have substantially the same shape. The first wide portion 613a and the second wide portion 613b may have different shapes. In the present embodiment, a plurality of first wide portions 613a have substantially the same shape, but the first wide portions 613a having different shapes may be mixed. Similarly, a plurality of second wide portions 613b have substantially the same shape, but the second wide portions 613b having different shapes may be mixed.

In the present embodiment, the first wide portion 613a is disposed to correspond to at least one of the first intersection portions 602a existing in the first sensing portion 611, and the plurality of first wide portions 613a are irregularly arranged. In addition, the second wide portion 613b is disposed to correspond to at least one of the second intersection portions 602b existing in the first connection portion 612, and the second wide portion 613b is disposed to correspond to all the second intersection portions 602b existing in the first connection portion 612. The existence ratio of the second wide portion 613b is preferably higher than the existence ratio of the first wide portion 613a. The existence ratio of the first wide portion 613a is a ratio of the number of the first wide portions 613a with respect to the number of the first intersection portions 602a in the first sensing portion 611, and the existence ratio of the second wide portion 613b is a ratio of the number of the second wide portions 613b with respect to the number of the second intersection portions 602b in the first connection portion 612.

As illustrated in Fig. 7, the first wide portion 613a may not exist in the first sensing portion 611.

In the present embodiment, it is preferable to satisfy the following Formulas (13) to (15) from the viewpoint of suppressing the decrease in reliability while improving the visibility.

$$A < B \ldots (13)$$

$$A = (A_1 + A_1)/N_1 \ldots (14)$$

$$B = (B_1 + B_2)/N_2 \ldots (15)$$

In the above Formula (14), $A_1$ is a total sum of the areas of the first wide portions 613a in one of the first sensing portions 611, $A_2$ is a total sum of the areas of the first intersection portions 602a in which the first wide portions 613a do not exist in one of the first sensing portions, and $N_1$ is the number of the first intersection portions 602a in one of the first sensing portions 611. In the above Formula (15), $B_1$ is a total sum of the areas of the second wide portions 613b in one of the first connection portions 612, $B_2$ is a total sum of the areas of the second intersection portions 602b in which the second wide portions 613b do not exist in one of the first connection portions 612, and $N_2$ is the number of the second intersection portions 602b in one of the first connection portions 612. The area of the intersection portion 602 is the area of the portion where the first conductor wire 601a and the second conductor wire 601b intersect with each other, and specifically, is the product of the width La of the first conductor wire 601a and the width Lb of the second conductor wire 601b.

From the viewpoint of improving the responsiveness of the first electrode 61, it is preferable that the sheet resistance $\rho_s$ of the first sensing portion 611 is in a range of 3 Ω/□ to 30 Ω/□ (3 Ω/□ $\le \rho_s \le$ 30 Ω/□). From the viewpoint of improving the reliability of the first electrode 61, it is preferable that the sheet resistance $\rho_c$ of the first connection portion 612 is in a range of 6 Ω/□ to 60 Ω/□ (6 Ω/□ $\le \rho_c \le$ 60 Ω/□). From the viewpoint of improving the reliability of the first electrode 61 while improving the responsiveness of the first electrode 61, it is preferable that the ratio ($\rho_s/\rho_c$) of the sheet resistance $\rho_s$ to the sheet resistance $\rho_c$ is in a range of 0.4 to 0.7 (0.4 $\le \rho_s/\rho_c \le$ 0.7).

As illustrated in Figs. 1 and 2, the second resin portion 70 has a rectangular outer shape and is made of a resin material having a light transmission property. As a resin material having a light transmission property, for example, the same material as the resin material which constitutes the above-mentioned first resin portion 50 can be used.

The second resin portion 70 is provided on the first resin portion 50 so as to cover the first conductor portion 60. A first opening 701 having a rectangular shape is formed on one side of the second resin portion. The first terminal 63 is exposed from the first opening 701, and thus, the first terminal 63 and an external circuit can be connected to each other.

The second conductor portion 80 is provided on the second resin portion 70. As illustrated in Fig. 8, the second conductor portion 80 is configured in a mesh shape of a plurality of conductor wires 801. Specifically, a second conductor portion 80 having a mesh shape in which square grids are repeatedly arranged is configured by allowing a plurality of third conductor wires 801a extending in a linear shape along the first direction and a plurality of fourth conductor wires 801b extending in a linear shape along the second direction to intersect with each other. In the present specification, the "third conductor wire 801a" and the "fourth conductor wire 801b" are collectively referred to as the "conductor wire 801" as necessary.

The second conductor portion 80 includes second electrodes 81, second lead wires 82, and second terminals 83. The second electrodes 81 are disposed so as to at least partially overlap with the sensing area 11. Each second electrode 81 extends in the Y direction in the figure, and the plurality of second electrodes 81 are arranged in parallel in the X direction in the figure. One end of the second lead wire 82 is connected to one longitudinal end of each second electrode 81. The second terminal 83 is connected to the other end of each second lead wire 82. The second terminal 83 is electrically connected to, for example, an external circuit. The second lead wires 82 and the second terminals 83 are disposed to overlap with the non-sensing area 12.

The number of the second electrodes 81 is not particularly limited and can be set arbitrarily. In addition, the number of the second lead wires 82 and the number of the second terminals 83 are set in accordance with the number of the second electrodes 81. The second lead wire 82 and the second terminal 83 may be configured to be in a mesh shape or may be configured to be in a solid pattern.

As illustrated in Fig. 8, the second electrode 81 is configured to have a mesh shape of the plurality of conductor wires 801. The second electrode 81 includes a plurality of second sensing portions 811 having a rhombic shape in plan view and a plurality of strip-shaped second connection portions 812 formed to be narrower than the second sensing portions 811. The second sensing portion 811 is configured to have a mesh shape of a plurality of conductor wires 801, and the plurality of second sensing portions 811 are arranged at substantially equal intervals along the Y direction. In this case, the second sensing portions 811 are disposed to correspond to the blank portions formed between the plurality of first sensing portions 611 so as not to overlap with the first sensing portions 611. The second connection portion 812 is configured to have a mesh shape of the plurality of conductor wires 801, and the plurality of second connection portions 812 electrically connect the corner portions of the adjacent second sensing portions 811 to each other. The second connection portion 812 intersects with the first connection portion 612 via the second resin portion 70 in plan view.

A third wide portion 813a is disposed at a third intersection portion 802a of the third conductor wire 801a and the fourth conductor wire 801b in the second sensing portion 811. Similarly, a fourth wide portion 813b is disposed at a fourth intersection portion 802b of the third conductor wire 801a and the fourth conductor wire 801b in the second connection portion 812.

Since the configurations of the second sensing portion 811, the second connection portion 812, the third wide portion 813a, and the fourth wide portion 813b are substantially the same as those of the first sensing portion 611, the first connection portion 612, the first wide portion 613a, and the second wide portion 613b, the redundant description thereof will be omitted, and the above description of the first sensing portion 611, the first connection portion 612, the first wide portion 613a, and the second wide portion 613b is used as it is.

As illustrated in Figs. 1 and 2, the third resin portion 90 is provided directly on the second resin portion 70 so as to cover the second conductor portion 80. The third resin portion 90 is an overcoat layer for protecting the second conductor portion 80 from the outside. In addition, by covering the second conductor portion 80 with the third resin portion 90, scattering of light on the surface of the second conductor portion 80 is suppressed, and the visibility of the wiring body 40 is improved.

A second opening 901 having a rectangular shape is formed on one side of the third resin portion 90. The second terminal 83 is exposed from the second opening 901, and thus, the second terminal 83 and the external circuit can be connected to each other. In addition, the second opening 901 overlaps with the first opening 701, and the first terminal 63 is also exposed from the second opening 901.

The third resin portion 90 is made of a resin material having a light transmission property. As the resin material having a light transmission property, the material similar to, for example, the resin material constituting the above-mentioned first resin portion 50 can be used.

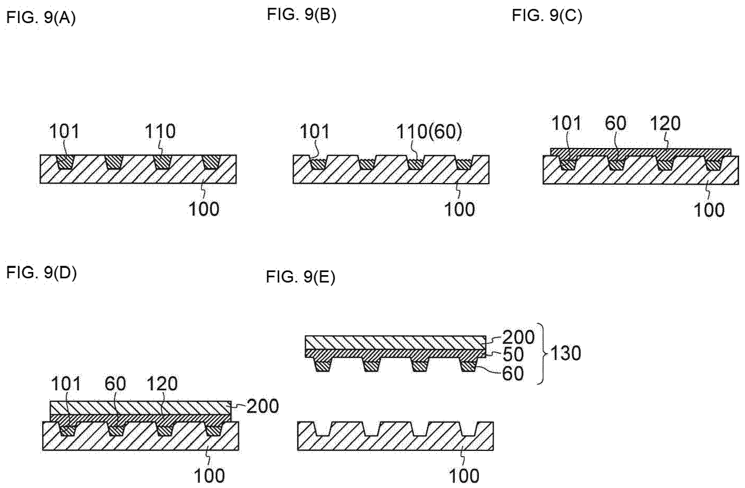

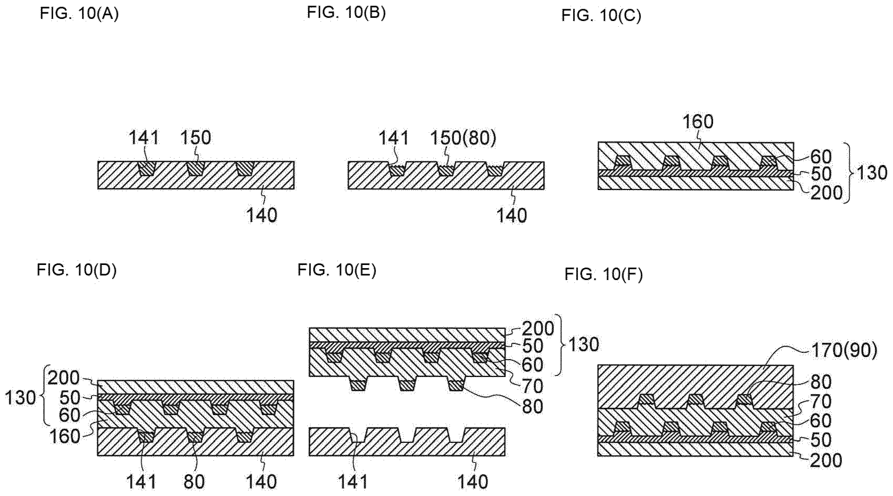

Next, a method of manufacturing the wiring board 20 according to the present embodiment will be described in detail with reference to Figs. 9(A) to 9(E) and Figs. 10(A) to 10(F). Figs. 9(A) to 9(E) and Figs. 10(A) to 10(F) are cross-sectional views illustrating the method of manufacturing the wiring board according to an embodiment of the invention.

First, as illustrated in Fig. 9(A), a first intaglio plate 100 in which a first recess 101 having a shape corresponding to the shape of the first conductor portion 60 is formed is filled with a first conductive material 110. In this case, a release layer may be formed on the surface of the first intaglio plate 100 to enhance the releasability of the first conductive material 110 from the first intaglio plate 100. As a method of filling the first intaglio plate 100 with the first conductive material 110, for example, a dispensing method, an inkjet method, and a screen printing method can be exemplified. Alternatively, a method of wiping, scraping, sucking, pasting, washing, and blowing off the applied first conductive material 110 other than the first recess 101 after application by a slit coating method, a bar coating method, a blade coating method, a dip coating method, a spray coating method, or a spin coating method can be exemplified. As the first conductive material 110, the above-described conductive paste is used.

Next, as illustrated in Fig. 9(B), the first conductive material 110 filled in the first recess 101 is solidified. The solidification treatment of the conductive material can be performed by using at least one of heating, irradiation with energy rays (infrared rays, ultraviolet rays, laser light, or the like), and drying.

Next, as illustrated in Fig. 9(C), a first resin material 120 is laid so as to cover the first conductor portion 60 in the first recess 101. As the first resin material 120, the material constituting the first resin portion 50 is used. As the method of laying the first resin material 120 on the first intaglio plate 100, a vapor deposition method, a sputtering method, an inkjet method, a photolithography method, and the like can be exemplified.

Next, as illustrated in Fig. 9(D), the transparent substrate 200 is pressed against the first intaglio plate 100 so that the first resin material 120 is interposed between the first intaglio plate 100 and the transparent substrate 200.

Next, the first resin material 120 on the first intaglio plate 100 is solidified. A method of the solidification treatment of the first resin material 120 can be performed by using at least one of heating, irradiation with energy rays (infrared rays, ultraviolet rays, laser light, or the like), and drying. By solidifying the first resin material 120, the first resin portion 50 is formed.

Next, as illustrated in Fig. 9(E), the transparent substrate 200, the first resin portion 50, and the first conductor portion 60 are released from the first intaglio plate 100. Hereinafter, a laminate of the transparent substrate 200, the first resin portion 50, and the first conductor portion 60 is also referred to as an intermediate body 130.

Next, as illustrated in Fig. 10(A), a second intaglio plate 140 in which a second recess 141 having a shape corresponding to the shape of the second conductor portion 80 is formed is filled with a second conductive material 150. As the second conductive material 150, the above-described conductive paste is used. As a method of filling the second recess 141 with the second conductive material 150, the same method as the method of filling the first recess 101 with the first conductive material 110 is used.

Next, as illustrated in Fig. 10(B), the second conductive material 150 with which the second recess 141 is filled is solidified. As a method of solidifying the second conductive material 150, the same method as the method of solidifying the first conductive material 110 is used.

Next, as illustrated in Fig. 10(C), the second resin material 160 is laid on the intermediate body 130 so as to cover the first conductor portion 60. As the second resin material 160, the material constituting the second resin portion 70 is used. As a method of laying the second resin material 160 on the intermediate body 130, the same method as the method of laying the first resin material 120 on the first intaglio plate 100 is used.

Next, as illustrated in Fig. 10(D), the intermediate body 130 is laid on the second intaglio plate 140, and the intermediate body 130 is pressed against the second intaglio plate 140.

Next, the second resin material 160 is solidified. As a method of solidifying the second resin material 160, the same method as the method of solidifying the first resin material 120 is used. The second resin portion 70 is formed by solidifying the second resin material 160.

Next, as illustrated in Fig. 10(E), the intermediate body 130, the second resin portion 70, and the second conductor portion 80 are released from the second intaglio plate 140.

Next, as illustrated in Fig. 10(F), a third resin material 170 is laid on the second resin portion 70 so as to cover the second conductor portion 80. As the third resin material 170, the material constituting the third resin portion 90 is used. As a method of laying the third resin material 170 on the second resin portion 70, the same method as the method of laying the first resin material 120 on the first intaglio plate 100 is used.

Next, the third resin material 170 is solidified. As a method of solidifying the third resin material 170, the same method as the method of solidifying the first resin material 120 is used. In this manner, the third resin portion 90 is formed. Next, the cover panel 30 (see Fig. 2) is attached onto the third resin portion 90. Accordingly, the wiring board 20 can be obtained.

The wiring body 40, the wiring board 20, and the touch sensor 10 according to the present embodiment exhibit the following effects.

In the present embodiment, the wide portion 613 is disposed to correspond to the intersection portion 602 of the first conductor wire 601a and the second conductor wire 601b in the first electrode 61, and the above Formula (8) is satisfied. In this case, since the electrical resistance can be reduced in the intersection portion 602 where the currents from the first conductor wire 601a and the second conductor wire 601b are concentrated, the occurrence of deterioration due to thermal stress in the vicinity of the intersection portion 602 is suppressed. In addition, the area Sc of the wide portion 613 can be suppressed, and thus, the wide portion 613 can be made difficult to be visible. As a result, it is possible to improve the visibility of the wiring body 40, and it is possible to improve the reliability of the wiring body 40. In particular, the area Sc of the wide portion 613 is set to be in a range of 6 $\mu$m$^2$ to 500 $\mu$m$^2$, so that it is possible to more significantly exhibit the effect of improving the visibility of the wiring body 40 and the effect of improving the reliability.

In the present embodiment, the width La of the first conductor wire 601a is set to be in a range of 1 to 5 $\mu$m, and the width Lb of the second conductor wire 601b is set to be in a range of 1 to 5 $\mu$m. Accordingly, it is possible to suppress breakage of the conductor wire 601 occurring in portions other than the intersection portion 602, and it is possible to prevent the conductor wire 601 from being easily visible.

In the present embodiment, the second wide portion 613b is disposed to correspond to at least one of the second intersection portions 602b existing in the first connection portion 612. For this reason, it is possible to reduce the electric resistance in the first connection portion 612 which is narrower than the first sensing portion 611 and in which current tends to be easily concentrated as compared to the first sensing portion 611. Accordingly, it is possible to further suppress the occurrence of deterioration due to thermal stress in the first connection portion 612.

In the present embodiment, the first wide portion 613a is disposed to correspond to at least one of the first intersection portions 602a existing in the first sensing portion 611, and the above Formula (10) is satisfied. In this case, the second wide portion 613b is disposed in the first connection portion 612, where current tends to be easily concentrated, so as to suppress the occurrence of deterioration due to thermal stress in the vicinity of the second intersection portion 602b, and the first wide portion 613a is also disposed in the first sensing portion 611 so as to reduce the difference between the light transmittance in the first sensing portion 611 and the light transmittance in the first connection portion 612. As a result, it is possible to improve the visibility of the entire first electrode 61.

In the present embodiment, the number of the second intersection portions 602b which are arranged in a direction perpendicular to the extending direction of the first connection portion 612 in the first connection portion 612 is set to three or less, so that it is possible to suppress the width of the first connection portion 612 from being excessively large, and it is possible to prevent the first connection portion 612 from being easily visible. In addition, by setting the upper limit value of the number of the second intersection portions 602b as described above, the electrostatic capacitance of the first connection portion 612 can be reduced, so that it is possible to improve the responsiveness of the first electrode 61.

In the present embodiment, since the above Formula (9) is satisfied, in the intersection portion 602 existing in the first electrode 61, it is possible to further suppress the occurrence of deterioration due to thermal stress in the vicinity of the intersection portion 602 where current tends to be easily concentrated.

The "touch sensor 10" in the present embodiment corresponds to an example of the "touch sensor" in the invention, the "wiring board 20" in the present embodiment corresponds to an example of the "wiring board" in the invention, the "cover panel 30" and the "transparent substrate 200" in the present embodiment correspond to an example of the "support" in the invention, and the "wiring body 40" in the present embodiment corresponds to an example of the "wiring body" in the invention.

The "first resin portion 50" in the present embodiment corresponds to an example of the "resin portion" in the invention, and the "first electrode 61" in the present embodiment corresponds to an example of the "conductor portion" in the invention. The "first conductor wire 601a" in the present embodiment corresponds to an example of the "first conductor wire" in the invention, and the "second conductor wire 601b" in the present embodiment corresponds to an example of the "second conductor wire" in the invention. The "intersection portion 602" in the present embodiment corresponds to an example of the "intersection portion" in the invention, and the "wide portion 613" in the present embodiment corresponds to an example of the "wide portion" in the invention. The "first sensing portion 611" in the present embodiment corresponds to an example of the "sensing portion" in the invention, and the "first connection portion 612" in the present embodiment corresponds to an example of the "connection portion" in the invention.

The embodiments described above are disclosed in order to facilitate the understanding of the invention, and are not disclosed to limit the invention. Therefore, each component disclosed in the above embodiments is intended to include all design changes and equivalents that fall within the technical scope of the invention.

For example, the touch sensor according to the present embodiment is a projection-type electrostatic capacitive touch panel sensor including a wiring body having two conductor portions. However, the invention is not particularly limited thereto, and a surface-type (capacitive coupling type) electrostatic capacitive touch panel sensor including one conductor portion can also be applied to the invention.

The touch sensor 10 according to the present embodiment is a touch sensor having a diamond pattern in which a plurality of first electrodes 61 including a first sensing portion 611 having a rhombic shape and a plurality of second electrodes 81 including a second sensing portion 811 having a rhombic shape are combined so as to intersect with each other. However, the invention is not particularly limited to that described above, the touch sensor may be a touch sensor in which a plurality of strip-shaped electrodes are combined to intersect with each other.

At the intersection portion 602, three or more conductor wires 601 may intersect with each other. In this case, two conductor wires with larger widths of the plurality of conductor wires 601 intersecting with each other in the intersection portion 602 are used as the first conductor wire 601a and the second conductor wire 601b.

For example, in the above-described embodiment, a metal material or a carbon-based material is used as the conductive material constituting the first conductor portion 60 and the second conductor portion 80. However, the invention is not particularly limited thereto, and a mixture of the metal material and the carbon-based material may be used.

Although not particularly illustrated, in the embodiment described above, the cover panel 30 and the transparent substrate 200 are used as the support of the wiring board 20. However, the invention is not particularly limited thereto. For example, a release sheet is provided on the lower surface of the first resin portion 50, and the wiring board may be configured by peeling off the release sheet at the time of mounting and adhering the first resin portion to a mounting object (a film, a surface glass, a deflection plate, a display glass, or the like).

In this case, electrostatic electricity is generated by peeling off the release sheet from the wiring body 40, and the electrostatic electricity flows through the conductor portions 60 and 80 of the wiring body 40, so that there is a problem in that, the intersection portions 602 and 802 are deformed and broken by Joule's heat or the resin portions 50, 70, and 90 in the vicinity of the intersection portions 602 and 802 are deformed by Joule's heat to reduce the reliability of the wiring body 40. Even in such a case, by applying the invention, the electrical resistance of the intersection portions 602 and 802 can be reduced, so that the occurrence of deterioration due to thermal stress in the vicinity of the intersection portions 602 and 802 is suppressed, and thus, the reliability of the wiring body 40 can be improved.

In the wiring board 20, a resin portion functioning as an adhesive layer may be provided between the wiring body 40 and the cover panel 30. In addition, the wiring body may be mounted on the above-mentioned mounting object via such a resin portion. In a case where the wiring body is mounted on a mounting object, the mounting object corresponds to an example of the "support" in the invention.

Furthermore, in the above-mentioned embodiment, a wiring body or a wiring board was described as being used for a touch sensor. However, the invention is not particularly limited thereto. For example, the wiring body may be used as a heater by allowing an electric current to flow through the wiring body to generate heat by resistance heating or the like. In this case, as the conductive particles, a carbon-based material having a relatively high electric resistance value is preferably used. Alternatively, by grounding a portion of the conductor portion of the wiring body, the wiring body may be used as an electromagnetic shielding shield. Alternatively, the wiring body may be used as an antenna. In this case, the mounting object on which the wiring body is mounted corresponds to an example of the "support" in the invention.

**[EXAMPLES]**

Hereinafter, the invention will be more specifically described with reference to examples and comparative examples. The following examples and comparative examples are for confirming the effects of the improvement in the visibility and the improvement in the reliability of the wiring body in the above-described embodiment.

<Example 1>

In Example 1, test samples were manufactured by the following method. That is, a recess formed on the surface of a metal intaglio plate was filled with a conductive paste (a conductive paste including a binder (polyester-based binder) and Ag particles), the conductive paste was solidified to form a conductor portion, a resin material (UV curable acrylic resin) in an formless state (uncured state) was applied onto the intaglio plate, and a substrate (PET film) was pressed against the intaglio plate with the resin material in the formless state being interposed, the resin material in the formless state was solidified to form a resin portion, and after that, the substrate, the resin portion, and the conductor portion were released from the intaglio plate. As the solidification treatment of the conductive paste, heating was performed at 150°C for 30 minutes. As the solidification treatment of the resin material in an formless state, ultraviolet light irradiation of 1000 mJ was performed.

A conductor pattern in which 30 electrodes are paralleled was set as a conductor pattern of the conductor portion. As the electrodes, 30 rhombus-shaped sensing portions formed in a mesh shape of a plurality of the conductor wires were arranged at intervals, and a plurality of the sensing portions were connected via a plurality of strip-shaped connection portions formed in a mesh shape of a plurality of the conductor wires. A connection portion of which one end was not connected to the sensing portion was disposed at one end of each of the electrodes. The length of one side of the sensing portion was set to 4 mm. The width (maximum width) of the connection portion was set to 0.8 mm. The widths La and Lb of the conductor wires constituting the electrodes were set as listed in Table 1. A wide portion was not formed at the intersection portion of the conductor wires existing in the sensing portion, and a wide portion having substantially perfect circle was formed at all the intersection portions of the conductor wires existing in the connection portion. The width (diameter) W of the wide portion was set as listed in Table 1. The aperture ratio of the conductor portion was set to be in the range of 96.5 to 98.0%. Test samples having the above configuration were produced. The product (La × Lb) of the widths of the conductor wires intersecting with each other of the manufactured test sample, the area Sc of the wide portion and, and the ratio (Sc/(La × Lb)) of the area Sc of the wide portion to the product (La × Lb) of the widths of the conductor wires are listed in Table 1.

In order to evaluate the visibility and reliability of the obtained test samples, the following electrostatic resistance inspection and outer appearance inspection were performed on the test samples.

<<Electrostatic Resistance Inspection>>

(Inspection Method)

A discharging test was performed according to IEC 61000-4-2 Ed2 by using an electrostatic tester (ESS-2000 produced by Noise Laboratory, an energy storage capacity: 150 pF, a discharging resistance: 330 Ω). Specifically, a metal plate connected to GND via two resistors (470 kΩ each), a 0.5 mm thick insulating plate, and the test sample were stacked in this order on a wooden desk, and an ESD generator was brought into contact with one end of the connection portion unconnected to the sensing portion. After that, contact discharging was performed. As discharging conditions, the output voltage (discharge voltage) was set to 6.0 kV, and the number of times of the discharging was set to three.

(Evaluation Method)

With respect to the test samples subjected to the discharging test, the presence or absence of disconnection in the conductor portion was evaluated. Specifically, the resistance value between the connection portion disposed at one end of the electrode and the sensing portion disposed at the other end of the electrode was measured, and the conduction of each electrode was evaluated. In addition, each connection portion was visually observed from the surface side of the test sample, and the presence or absence of disconnection in the connection portion was evaluated. As an evaluation standard, in a case where a test sample corresponds to both of "conduction of the electrode can be confirmed" and "disconnection portion in each connection portion cannot be confirmed", this case is regarded as having the reliability improvement effect and is indicated by "B" in performing the evaluation; and in a case where a test sample does not correspond to any one of "conduction of the electrode can be confirmed" and "disconnection portion in each connection portion cannot be confirmed", this case is regarded as being poor in the reliability improvement effect and is indicated by "C" in performing the evaluation.

<<Outer Appearance Inspection>>

(Inspection Method)

The following transmitted light inspection and reflected light inspection were conducted in a room (dark room) where a light source of a three-wavelength white fluorescent lamp (illuminance: 1300 lx) was installed and where external light is blocked.

(a) Transmitted Light Inspection: The above-mentioned light source was disposed at a position 50 cm away from the back surface of the test sample. The surface of the test sample was visually observed from a position 30 cm away from the surface of the test sample.
(b) Reflected Light Inspection: A light shielding black substrate is disposed on the back surface of the test sample, and the light source is disposed so that the reflected light illuminance on the surface of the test sample is 1000 lx or more. The surface of the test sample was visually observed from a position 30 cm away from the surface of the test sample.

(Evaluation Method)

In a case where a test sample corresponds to both of "there are not any conductor portion which are visible" and "there is no glare due to reflection", this case is regarded as being excellent in the visibility improvement effect and is indicated by "A" in performing the evaluation; in a case where a test sample corresponds to any one of "there are conductor portions which are slightly visible" and "glare due to reflection can be confirmed", this case is regarded as having the visibility improvement effect and is indicated by "B" in performing the evaluation; and in a case where a test sample corresponds to both of "there are conductor portions which are remarkably visible" and "glare due to reflection can be confirmed", this case is regarded as being poor in the visibility improvement effect and is indicated by "C" in performing the evaluation.

The test results of Example 1 are listed in Table 1.

<Examples 2 to 4>

In Examples 2 to 4, test samples were manufactured in the same manner as in Example 1 except that the widths La and Lb of the conductor wires and the widths W of the wide portions were set as listed in Table 2. These test samples were subjected to the electrostatic resistance inspection and the outer appearance inspection. The results are listed in Table 2.

<Examples 5 to 7>

In Examples 5 to 7, test samples were manufactured in the same manner as in Example 1 except that the widths La and Lb of the conductor wires and the widths W of the wide portions were set as listed in Table 3. These test samples were subjected to the electrostatic resistance inspection and the outer appearance inspection. The results are listed in Table 3.

<Comparative Examples 1 and 2>

As a comparative example of Examples 1 and 2, test samples were manufactured in the same manner as in Example 1 except that the widths W of the wide portions were set as listed in Table 1. The test samples were subjected to the electrostatic resistance inspection and the outer appearance inspection. The results are listed in Table 1.

<Comparative Examples 3 to 6>

As comparative examples of Examples 3 to 6, test samples were manufactured in the same manner as in Example 1 except that the widths La and Lb of the conductor wires and the widths W of the wide portions were set as listed in Table 2. These test samples were subjected to the electrostatic resistance inspection and the outer appearance inspection. The results are listed in Table 2.

<Comparative Examples 7 to 8>

As comparative examples of Examples 7 to 8, test samples were manufactured in the same manner as in Example 1 except that the widths La and Lb of the conductor wires and the widths W of the wide portions were set as listed in Table 3. These test samples were subjected to the electrostatic resistance inspection and the outer appearance inspection. The results are listed in Table 3.

[Table 1]

Table 1

| | Width of conduct or wire La, Lb ($\mu$m) | La $\times$ Lb ($\mu$m$^2$) | Width of wide portion W ($\mu$m) | Area of wide portion Sc ($\mu$m$^2$) | Sc/ (La $\times$ Lb) | Reliability evaluation (Electrostatic resistance evaluation) | Visibility evaluation |
|---|---|---|---|---|---|---|---|
| Comparative Example 1 | 1 | 1 | 1.5 | 1.8 | 1.8 | C | A |
| Comparative Example 2 | 1 | 1 | 2.0 | 3.1 | 3.1 | C | A |
| Example 1 | 1 | 1 | 3.0 | 7.1 | 7.1 | B | A |

[Table 2]

Table 2

| | Width of conductor wire La, Lb (μm) | La × Lb (μm²) | Width of wide portion W (μm) | Area of wide portion Sc (μm²) | Sc/ (La × Lb) | Reliability evaluation (Electrostatic resistance evaluation) | Visibility evaluation |
|---|---|---|---|---|---|---|---|
| Comparative Example 3 | 2.5 | 6.25 | 3.0 | 7.1 | 1.1 | C | A |
| Comparative Example 4 | 2.5 | 6.25 | 5.0 | 19.6 | 3.1 | C | A |
| Comparative Example 5 | 2.5 | 6.25 | 6.3 | 30.7 | 4.9 | C | A |
| Example 2 | 2.5 | 6.25 | 7.5 | 44.2 | 7.1 | B | A |
| Example 3 | 2.5 | 6.25 | 10.0 | 78.5 | 12.6 | B | A |
| Example 4 | 2.5 | 6.25 | 15.0 | 176.7 | 28.3 | B | B |
| Comparative Example 6 | 2.5 | 6.25 | 20.0 | 314.2 | 50.3 | B | C |

[Table 3]

Table 3

| | Width of conductor wire La, Lb (μm) | La × Lb (μm²) | Width of wide portion W (μm) | Area of wide portion Sc (μm²) | Sc/ (La × Lb) | Reliability evaluation (Electrostatic resistance evaluation) | Visibility evaluation |
|---|---|---|---|---|---|---|---|
| Comparative Example 7 | 5 | 25 | 7.5 | 44.2 | 1.8 | C | A |
| Comparative Example 8 | 5 | 25 | 10.0 | 78.5 | 3.1 | C | A |
| Example 5 | 5 | 25 | 15.0 | 176.7 | 7.1 | B | A |
| Example 6 | 5 | 25 | 20.0 | 314.2 | 12.6 | B | A |
| Example 7 | 5 | 25 | 25.0 | 490.9 | 19.6 | B | B |

<Evaluation of Examples and Comparative Examples>

As listed in Tables 1 to 3, in comparison with Comparative Examples 1 to 8 in which the ratio (Sc/(La × Lb)) is set to be out of the range of the above Formula (8), in Examples 1 to 7 in which the ratio (Sc/(La × Lb)) of the area Sc of the wide portion to the product of the widths La and Lb of the conductor wires is set to be within the range of the above Formula (8), it can be confirmed that generation of disconnection due to static electricity does not occur, and the visibility or glare of the conductor portion are suppressed.

In addition, as listed in Tables 1 to 3, in comparison with Comparative Examples 1 to 8 in which the area Sc of the wide portion is set to be out of the range of the above Formula (8), in Examples 1 to 7 in which the area Sc of the wide portion is set to be within the range of the above Formula (8), it can be confirmed that generation of disconnection due to static electricity does not occur, and the visibility or glare of the conductor portion are suppressed.

That is, from the results of Examples 1 to 7, by setting the ratio (Sc/(La × Lb)) to be within the range of the above Formula (8), it can be confirmed that it is possible to appropriately realize both the improvement of the visibility and the improvement of the reliability of the wiring body.

**[EXPLANATIONS OF LETTERS OR NUMERALS]**

| | |
|---|---|
| 10 | TOUCH SENSOR |
| 11 | SENSING AREA |
| 12 | NON-SENSING AREA |
| 20 | WIRING BOARD |
| 30 | COVER PANEL |
| 31 | TRANSPARENT PORTION |
| 32 | SHIELDING PORTION |
| 40 | WIRING BODY |
| 50 | FIRST RESIN PORTION |
| 60 | FIRST CONDUCTOR PORTION |
| 601a | FIRST CONDUCTOR WIRE |
| 601b | SECOND CONDUCTOR WIRE |
| 602 | INTERSECTION PORTION |
| 61 | FIRST ELECTRODE |
| 611 | FIRST SENSING PORTION |
| 612 | FIRST CONNECTION PORTION |
| 613 | WIDE PORTION |
| 62 | FIRST LEAD WIRE |
| 63 | FIRST TERMINAL |
| 70 | SECOND RESIN PORTION |
| 701 | FIRST OPENING |
| 80 | SECOND CONDUCTOR PORTION |
| 801a | THIRD CONDUCTOR WIRE |
| 801b | FOURTH CONDUCTOR WIRE |
| 81 | SECOND ELECTRODE |
| 811 | SECOND SENSING PORTION |
| 812 | SECOND CONNECTION PORTION |
| 82 | SECOND LEAD WIRE |
| 83 | SECOND TERMINAL |
| 90 | THIRD RESIN PORTION |
| 901 | SECOND OPENING |
| 100 | FIRST INTAGLIO PLATE |
| 101 | FIRST RECESS |
| 110 | FIRST CONDUCTIVE MATERIAL |
| 120 | FIRST RESIN MATERIAL |
| 130 | INTERMEDIATE BODY |
| 140 | SECOND INTAGLIO PLATE |
| 141 | SECOND RECESS |
| 150 | SECOND CONDUCTIVE MATERIAL |
| 160 | SECOND RESIN MATERIAL |
| 170 | THIRD RESIN MATERIAL |
| 200 | TRANSPARENT SUBSTRATE |

**Claims**

1. A wiring body comprising:

   a resin portion; and
   a conductor portion which is provided on the resin portion and has a mesh shape in which first conductor wires and second conductor wires intersect with each other, wherein
   the conductor portion includes at least one wide portion disposed to correspond to an intersection portion of the first conductor wire and the second conductor wire, and
   the following Formula (1) is satisfied:

$$6 < Sc/(La \times Lb) \leq 30 \ldots (1)$$

in the above Formula (1), Sc is an area of the wide portion, La is a width of the first conductor wire, and Lb is a width of the second conductor wire.

2. The wiring body according to claim 1, wherein
the following Formula (2) is satisfied.

$$6 \ \mu m^2 \leq Sc \leq 500 \ \mu m^2 \ldots (2)$$

3. The wiring body according to claim 1, wherein
the following Formulas (3) and (4) are satisfied.

$$1 \ \mu m \leq La \leq 5 \ \mu m \ldots (3)$$

$$1 \ \mu m \leq Lb \leq 5 \ \mu m \ldots (4)$$

4. The wiring body according to any one of claims 1 to 3, wherein
the conductor portion includes:

sensing portions which are arranged at intervals along a predetermined direction; and
connection portions which are formed to be narrower than the sensing portions and connect the sensing portions adjacent to each other, and
the wide portion is disposed to correspond to at least one of the intersection portions existing in the connection portion.

5. The wiring body according to claim 4, wherein
the wide portion is disposed to correspond to at least one of the intersection portions existing in the sensing portion, and
the following Formulas (5) to (7) are satisfied:

$$A < B \ldots (5)$$

$$A = (A_1 + A_1)/N_1 \ldots (6)$$

$$B = (B_1 + B_2)/N_2 \ldots (7)$$

in the above Formula (6), $A_1$ is a total sum of the areas of the wide portions in one of the sensing portions, $A_2$ is a total sum of the areas of the intersection portions in which the wide portions do not exist in one of the sensing portions, and $N_1$ is the number of the intersection portions in one of the sensing portions; and in the above Formula (7), $B_1$ is a total sum of the areas of the wide portions in one of the connection portions, $B_2$ is a total sum of the areas of the intersection portions in which the wide portions do not exist in one of the connection portions, and $N_2$ is the number of the intersection portions in one of the connection portions.

6. The wiring body according to claim 4 or 5, wherein,
in the connection portion, the number of the intersection portions that are arranged in a direction perpendicular to the extending direction of the connection portion is three or less.

7. The wiring body according to any one of claims 1 to 6, wherein
the following Formula (8) is satisfied:

$$La + Lb < W \ldots (8)$$

in the above Formula (8), W is a width of the wide portion.

8. A wiring board comprising:

   the wiring body according to any one of claims 1 to 7; and
   a support which supports the wiring body.

9. A touch sensor comprising the wiring board according to claim 8.

$$La + Lb < W \ldots (8)$$

FIG. 1

FIG. 2

FIG. 3

EP 3 605 289 A1

FIG. 4

EP 3 605 289 A1

FIG. 5

EP 3 605 289 A1

FIG. 6

601b  601a

VC  613B

SECOND DIRECTION  Y  FIRST DIRECTION

Z  X

FIG. 7

SECOND DIRECTION

FIRST DIRECTION

EP 3 605 289 A1

FIG. 8

FIG. 9(A)

FIG. 9(B)

FIG. 9(C)

101 110

101 110(60)

101 60 120

100

100

100

FIG. 9(D)

FIG. 9(E)

200
50 } 130
60

101 60 120

200

100

100

EP 3 605 289 A1

FIG. 10(A)

FIG. 10(B)

FIG. 10(C)

141  150

141  150(80)

160

140

140

60
50  } 130
200

FIG. 10(D)

FIG. 10(E)

FIG. 10(F)

200
50  } 130
60
70
80

170(90)

200
50  } 130
60
160

80
70
60
50
200

141  80  140

141  140

EP 3 605 289 A1

## INTERNATIONAL SEARCH REPORT

| International application No. |
| --- |
| PCT/JP2018/012129 |

**A. CLASSIFICATION OF SUBJECT MATTER**
Int.Cl. G06F3/041(2006.01)i, G06F3/044(2006.01)i, H05K1/02(2006.01)i

According to International Patent Classification (IPC) or to both national classification and IPC

**B. FIELDS SEARCHED**

Minimum documentation searched (classification system followed by classification symbols)
Int.Cl. G06F3/041, G06F3/044, H05K1/02

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 3192845 U (INNOLUX DISPLAY CORP.) 04 September 2014, paragraphs [0014]-[0017], fig. 1A-2B (Family: none) | 1, 7-9<br>2-4, 6<br>5 |
| Y | JP 2012-108845 A (FUJIFILM CORP.) 07 June 2012, paragraphs [0020], [0067], fig. 8, 10 & KR 10-012-0054531 A & TW 201232632 A | 2-4, 6 |
| A | JP 2015-204066 A (DAINIPPON PRINTING CO., LTD.) 16 November 2015, entire text, all drawings (Family: none) | 1-9 |

☐ Further documents are listed in the continuation of Box C.     ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 14 June 2018 (14.06.2018) | 26 June 2018 (26.06.2018) |

| Name and mailing address of the ISA/<br>   Japan Patent Office<br>   3-4-3, Kasumigaseki, Chiyoda-ku,<br>   Tokyo 100-8915, Japan | Authorized officer<br><br><br>Telephone No. |

Form PCT/ISA/210 (second sheet) (January 2015)

**EP 3 605 289 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017072259 A

- JP 2012108845 A